# EUROPEAN PATENT SPECIFICATION

(11) **EP 0 686 073 B1**
(45) Date of publication and mention of the grant of the patent: **22.04.1998**
(21) Application number: 94909498.1
(22) Date of filing: 04.02.1994
(51) Int. Cl.: B23K 1/20, B23K 35/34, B23K 35/363

(54) **NO-CLEAN, LOW-RESIDUE, VOLATILE ORGANIC COMPOUND FREE SOLDERING FLUX AND METHOD OF USE**
RÜCKSTANDSARMES, VON FLÜCHTIGEN ORGANISCHEN VERBINDUNGEN FREIES UND KEINE REINIGUNG ERFORDERNDES FLUSSMITTEL SOWIE VERFAHREN ZU DESSEN VERWENDUNG
FLUX DE BRASAGE NE NECESSITANT PAS DE NETTOYAGE, LAISSANT PEU DE RESIDUS ET EXEMPT DE COMPOSES ORGANIQUES VOLATILS, ET METHODE D'UTILISATION

(30) Priority: 05.02.1993 US 14201; 05.02.1993 US 14203
(43) Date of publication of application: 13.12.1995
(73) Proprietor: STEFANOWSKI, Krystyna, Mt. Prospect, IL 60056 (US)
(72) Inventor: STEFANOWSKI, Krystyna, Mt. Prospect, IL 60056 (US)
(74) Representative: Müller, Frithjof E., Dipl.-Ing.
(86) International application number: US9400942
(87) International publication number: WO9417950

(56) References cited:
- EP-A- 0 538 822
- US-A- 3 424 625
- US-A- 3 723 191
- US-A- 4 478 650
- US-A- 4 601 763
- US-A- 4 708 751
- US-A- 5 085 365
- US-A- 5 281 281

## Description

### Field of The Invention

The invention relates to no-clean (low-residue) soldering fluxes.

### BACKGROUND OF THE INVENTION

Fluxes comprised of dicarboxylic acids as fluxing agents are described in the seminal U.S. patent of Ernest G. Tiegel, U.S. Patent 3,424,625. Solutions comprising a major portion of dicarboxylic acids dissolved in a minor portion of organic solvents such as lower alcohols, ethers, aldehydes, ketones and dimethyl sulfoxide are described in the Tiegel patent.

U.S. Patent 4,708,751 discloses low levels of dicarboxylic acids (less than 3.5%) dissolved in organic solvents and other ingredients including low levels of rosin (less than 2%).

Halogen-free fluxes which are also rosin-free utilizing organic acid based fluxing agents are also described in the art.

U.S. Patent 4,601,763 describes rosin-free and halogen-free fluxes containing low levels of dicarboxylic acids (3%) dissolved in organic solvent(s).

In U.S. Patent 5,085,365, the environmental problem with using cholorfluorcarbon (CFC) solvents to remove rosin flux residue is addressed. CFC solvents evaporate into the atmosphere and cause the depletion of the protective ozone layer in the stratosphere. U.S. Patent 5,085,365 describes the use of polycarboxylic acids such as citric acid as fluxing agents. Where the fluxes of U.S. Patent 5,085,365 are used, rinsing is required -- and thereafter, the rinse water needs to be processed because it is necessary to remove acid flux residue therefrom.

Another alternative to using rosin fluxes and cleaning with environmentally detrimental solvents is to use fluxes with a low solids content (less than 6%) as described in U.S. Patent 4,708,751, where low levels of fluxing agent, namely, less than about 3.5% are described. The flux described in U.S. Patent 4,708,751 is known in the electronics industry as a no-clean, low-residue or low-solids flux. No rinsing is required for this type of flux.

Document EP-A-538822, published on 28.4.93 and which is state of the art according to Art. 54(3) EPC, discloses a foaming soldering flux comprising at least one water-soluble organic acid having at least two carboxylic groups, water, and at least one foaming agent. According to this prior art, the organic acid preferably comprises citric acid in a concentration from about 0.5 to 99.5 wt% in the soldering flux.

The concentration of the foaming agent ranges from 0.0001 to 5 wt%, preferably from about 0.0002 to 0.04wt%. The water may be deionized water, and the foaming agent may be a non-ionic surfactant.

The current and developing problem with low-residue fluxes of all types is that such fluxes are based on alcohol and/or other volatile organic compound solvents. Such fluxes are applied to the bottom of a printed circuit assembly by pumping the flux into a wave, spraying or passing air into the flux to create a foam head and then conveying the printed circuit assembly over the flux. The next step in the process is to convey the assembly over or through a preheater to evaporate away the volatile solvent and activate the flux. Then the assembly is conveyed across a melted solder wave or pot. This rapid evaporation of the volatile solvent permits high speed conveying and soldering without spattering when the assembly touches the melted solder.

Volatile Organic Compounds (VOCs) have been described in the Federal Register (Vol. 55, No. 126 Friday, June 29, 1990) Rules and Regulations as "any organic compound which participates in atmospheric photo-chemical reactions." Already the State of California has recognized that VOCs emitted into the lower atmosphere contribute to the formation of smog by photochemical reaction and requires record keeping of VOC emissions.

Fluxes in use by the electronics industry for mechanized soldering of printed circuit assemblies either contain undesirable VOCs, or, if water-based, contain conductive and/or undesirable levels of corrosive organic acids which must be removed with water after fluxing.

The present invention provides a VOC-free, no-clean, low-residue flux using a demineralized water-based solvent system and a foaming system which includes a nonionic surfactant and a nonvolatile organic component that is a cosolvent with the demineralized water.

### SUMMARY OF THE INVENTION

It is an objective of the present invention to provide suitable fluxes for mechanized soldering of electronic assemblies. The fluxes contain no volatile organic compound solvents.

It is a further objective of the present invention to provide foam fluxes which when applied by wave, foaming or spraying, achieve high quality soldering and leave a low residual level of non-corrosive, non-conductive fluxing agent which does not require removal after soldering.

In accordance with the first embodiment of the invention as defined by claim 1, the fluxes accomplish the foregoing objectives by use of VOC-free formulas comprising a plurality of active fluxing agents and one or more nonionic surfactants that are dissolved in a cosolvent system comprised of demineralized water and a nonvolatile solvent. Demineralized water is water treated by demineralization to remove minerals usually present in ionized form, typically by ion-exchange, distillation, or dialysis. Demineralized water obtained by ion-exchange is referred to herein as deionized water. The active fluxing agents are present at levels of about 1% to about 4% by weight. Preferably the total amounts of active fluxing agent is present in amounts of from about 1% to about 3% by weight. The active fluxing agent component in the flux of the present invention is comprised of at least two fluxing agents that are selected from mixtures of (1) saturated and/or unsaturated dicarboxylic acids containing two to ten carbons; (2) one or more of the previously described dicarboxylic acids in combination with one or more monocarboxylic acid(s) and/or hydroxy acid(s); and (3) combinations of monocarboxylic acids, combinations of hydroxy acids, preferably mono- or dicarboxylic hydroxy acids, or combinations or monocarboxylic and hydroxy acids.

In accordance with the second embodiment of the present invention as defined by claim 9, the fluxes accomplish the foregoing objectives by use of VOC-free formulas consisting essentially of a plurality of active fluxing agents and one or more nonionic surfactants that are dissolved in demineralized water. Demineralized water is water treated by demineralization to remove minerals usually present in ionized form, typically by ion-exchange, distillation, or dialysis. Demineralized water obtained by ion-exchange is referred to herein as deionized water. The active fluxing agents are present at levels of about 1% to about 4% by weight. Preferably the total amounts of active fluxing agent is present in amounts of from about 1% to about 3% by weight. The active fluxing agent component in the flux of the present invention is comprised of at least two fluxing agents that are selected from mixtures of (1) saturated and/or unsaturated dicarboxylic acids containing two to ten carbons; (2) one or more of the previously described dicarboxylic acids in combination with one or more monocarboxylic acid(s) and/or hydroxy acid(s); and (3) combinations of monocarboxylic acids, combinations of hydroxy acids, preferably mono- or dicarboxylic hydroxy acids, or combinations of monocarboxylic and hydroxy acids.

### DETAILED DESCRIPTION OF THE INVENTION

In accordance with the first embodiment of the invention, the flux solvent is comprised of demineralized water and nonvolatile organic solvent(s). The fluxing agent is present as solute in the flux solvent system. Suitable fluxing agents are mono- and/or dicarboxylic acids and/or hydroxy acids. One or more nonionic surfactants are also present in the flux. The total solids content of the flux (excluding water and cosolvent) is less than about 5% by weight, with at least about 1% fluxing agent being required. Fluxing agent content in the range of from at least about 1% to about 4% by weight achieves the dual objectives of satisfactory fluxing without the need to clean the soldered area after application of solder. It has been observed that in the flux formulations of the first embodiment of the invention, fluxing is enhanced by using a plurality of fluxing agents.

The combination of acids provides an expanded melting range at the elevated soldering temperature levels where the deionized water solvent is evaporated and also provides enhanced wetting. The combination of acids includes combinations of elevated/high melting point acids such as succinic and adipic acids and/or combinations of high melting acids mixed with smaller quantities of lower melting acids such as glutaric acid. Combining acids achieves broadening of the fluxing melting range which falls within the range delimited by the solder melting point (solidus point) and the upper soldering temperatures; that is a temperature range typically from about 180°C to about 260°C. The combination of acids also enhances precleaning during preheating. It has been observed that there is an expanded window of flux activity when the melting range is increased.

Examples of acids among those suitable as fluxing agents in the soldering flux of the first and second embodiments of the invention are:
- dicarboxylic acids:: oxalic, adipic, succinic, malonic, maleic, glutaric, pimelic, suberic, azelaic, and sebacic acids.
- hydroxy acids:: malic, tartaric, citric, lactic, mandelic, glyceric, and glycolic acids.
- monocarboxylic acids:: valeric, caproic, phenylacetic, benzoic, salicylic, and aminobennzoic acids.

The organic solvent incorporated into the foam flux solution of the first embodiment of the invention can be categorized alternatively as part of a flux cosolvent system or as a component of a foaming system. The organic solvent required in the present foam flux solution contributes to both systems.

The cosolvent selected is a nonvolatile organic solvent that forms a cosolvent system with demineralized water. The cosolvent has a boiling point above about 190°C and a vapor pressure below 13,3 Pa (0.1 mm Hg) at 25°C. It is present in an amount of from about 1% to about 5% by weight based on the total weight of the flux, most preferably from about 2% to about 4% by weight. The cosolvent in the flux of the first embodiment of the invention inhibits decomposition of the fluxing agents during exposure to hot solder and also further broadens the melting range of the mixture of fluxing agents. The cosolvent may be present in an amount by weight of about 1% to about 5%. Preferably a plurality of solvents is used. Where a plurality of cosolvents are used, they may be selected from the same or different class of solvents.

Examples of cosolvents that are among the cosolvents that may be used in the flux of the first embodiment of the invention are: glycerine and polyhydroxy alcohols such as alkylene polyols, including, for example, ethylene, propylene, butylene, and hexylene polyols; high molecular weight esters and in particular dibasic acid esters, with aliphatic dibasic acid esters of dicarboxylic acids corresponding to suitable fluxing agents being preferred; glycol ether esters, including, for example, diethylene glycol butyl ether acetate, tripropylene glycol methyl ether acetate, ethylene glycol phenyl ether acetate, diethylene glycol ethyl ether acetate; and, aliphatic dibasic esters such as dimethyl adipate, dimethyl glutarate and dimethyl succinate and combinations thereof. As noted previously, preferably a plurality of solvents make up the cosolvent which is used with the demineralized water. The organic cosolvents, it should be noted, appropriately are characterized in combination with the nonionic surfactant required by the first embodiment of the invention as part of the foaming system in the flux of the present invention.

As will be noted by reference to the specifically exemplified compounds of the cosolvent classes, the aliphatic substitutes of the cosolvents preferably are lower alkyls. The aliphatic dibasic esters are available commercially, suitably as mixtures which contain only trace amounts of volatile organic solvents.

The presence of a nonionic surfactant is essential to the first embodiment of the invention. The nonionic surfactant and organic solvent form the foaming system of the foaming flux.

In the first embodiment of the invention both cosolvent and surfactant achieve acceptable levels of flux wet out and spread on the metal surface. The foam system selected cannot foam too much or the foam head will be too stable to allow the flux bubbles to pop on the surface being fluxed and soldered. In the flux compositions of the first embodiment of the invention, the surfactant, which is nonionic, also provides the added and important attribute of enhancing the heat stability of the flux. Added heat stability impedes boil-away during soldering, which at the low flux agent content required by the first embodiment of the invention must be arrested/ameliorated. Thus, both cosolvent and surfactant contribute to heat stabilization of the flux.

Examples of nonionic surfactants that are suitable for use in the soldering fluxes of the first embodiment of the invention are: phenoxypolyethoxy ethanols; perfluoralkyl alcohols; glycol fatty acid esters such as glycerol monolaurate, and/or ethylene glycol distearate; alkylaryl polyether alcohols; tertiary acetylenic glycols; ethoxylated polyoxypropylenes; and, alkoxylated phenols such as alkoxylated bisphenols. One or more nonionic surfactants may be used.

Optionally an anticorrosion agent is used to prevent/minimize oxidation of the metals being soldered. The quantities used are minimal, generally by weight based on total weight of the flux, less than about 0.5% and typically less than about 0.1% by weight. Most preferably the anticorrosion agent is present in an amount of about 0.05% by weight. Examples of anticorrosion agents among others suitable for use in the flux of the first embodiment of the invention are benzimidazole, benzotriazole and imidazole.

Soldering fluxes of the first embodiment of the invention are illustrated by reference the non-limiting examples which follow below.

### EXAMPLE 1

| Fluxing Agent | |
|---|---|
| adipic acid | 1.0 weight % |
| succinic acid | 1.5 weight % |

| Foaming System | |
|---|---|
| Surfactant | |
| alkoxylated bisphenol A* | 0.3 weight % |

| Organic Solvent (nonvolatile organic cosolvent) | |
|---|---|
| hexylene glycol | 3.5 weight % |
| dimethyl adipate | 0.75 weight % |
| Deionized water | 92.6 weight % |

| Corrosion Inhibitor | |
|---|---|
| triazole | 0.35 weight % |

| | |
|---|---|
| * MACOL 99A is a product of PP/G Mazer Chemical Co., 3938 Porett Drive Gurnee, IL 60031 | |

### EXAMPLE 2

| Fluxing Agent | |
|---|---|
| adipic acid | 1.5 weight % |
| glutaric acid | 0.3 weight % |
| aminobenzoic acid | 0.2 weight % |

| Foaming System | |
|---|---|
| Surfactant | |
| perfluoroalkylethanol | 0.2 weight % |

| Organic Solvent | |
|---|---|
| diethylene glycol ethyl ether acetate | 2.0 weight % |
| glycerine | 1.8 weight % |
| Deionized Water | 94.0 weight % |

### EXAMPLE 3

A series of experiments were conducted using the flux formulations of the first embodiment of the invention to evaluate the performance under production conditions. The equipment used for testing was an automatic wave soldering machine (Electrovert Mini-Pac) consisting of a foam fluxing station, preheater and wave solder pot, all inline and over which a conveyor carries printed circuit board assemblies. The printed circuit board was mounted into a dual rail fixture which was placed onto the conveyor.

For this testing, a variety of printed circuit boards were used either to produce samples for further testing of the electrical properties of the flux residue or to evaluate the ideal machine control parameters for producing acceptable soldering. Printed circuit boards were the standard IPC (Institute for Interconnecting and Packaging Electronic Circuits) B-25 which contains plated through copper holes and comb patterns for insulation resistance testing. Also used were a variety of printed circuit boards with solder plating either unfused or fused as well as bare copper boards, all double-sided with plated through holes.

After the circuit boards were placed in the fixture and on the conveyor, they traveled at a speed of 1,5 m (5 feet) per minute across a wave of flux foam created by passing air into an aerating stone in the foam fluxing unit. It was found helpful to use a low volume air knife after the application of the flux to blow off any extra dripping flux, but this is not always necessary, depending on the action of the particular machine. Alternatively, the flux was applied by spraying to achieve a uniform coating on the circuit board surface.

An observation of the flux composition of the first embodiment of the invention during the eight hours of foaming established that both the specific gravity and acid number were little changed because of the aeration. The following measurements underscore the advantages of the flux of the present invention over its alcohol-based counterpart.

| Test Parameter | Water-based Flux | Alcohol-based Flux |
|---|---|---|
| | | |

| Specific gravity @ 25°C | | |
|---|---|---|
| Initial | 1.006 | 0.813 |
| 1-hour | 1.006 | 0.824 |
| 2-hours | 1.007 | 0.829 |
| 3-hours | 1.011 | 0.832 |
| 4-hours | 1.011 | 0.833 |
| 5-hours | 1.010 | 0.836 |
| 6-hours | 1.010 | 0.837 |
| 7-hours | 1.010 | 0.839 |
| 8-hours | 1.010 | 0.840 |
| Increase | 0.004 | 0.027 |

| Acid Number g KOH/Kg Flux | | |
|---|---|---|
| Initial | 21.15 | 13.89 |
| 1-hour | 21.17 | 14.99 |
| 2-hours | 21.25 | 16.34 |
| 3-hours | 21.58 | 16.76 |
| 4-hours | 21.58 | 18.62 |
| 5-hours | 22.02 | 19.14 |
| 6-hours | 21.54 | 19.86 |
| 7-hours | 22.04 | 20.34 |
| 8-hours | 21.64 | 21.18 |
| Increase | 0.49 | 7.29 |

The specific gravity is a direct indication of the rapid loss of the alcohol solvent as it evaporates into the atmosphere. This evaporation loss necessitates constant monitoring of the flux to replace the alcohol. The other measure of flux composition control is the acid number which is determined by titration and reported as grams of potassium hydroxide per liter of flux. As the solvent portion of the flux evaporates, the solids or active portion will increase accordingly.

It can readily be seen from the test data that the constant checking of flux composition required of the conventional alcohol-based fluxes is eliminated by using the water-based flux of the first embodiment of the present invention. The low volatility cosolvent improved the heat stability of the flux by extending the time for thermal decomposition of the organic acids. It was determined that the optimum amount of cosolvent was about 1-5%, a higher amount adversely affecting the electrical resistance properties of the residue.

After application of the flux to the bottom side of the printed circuit board, the conveyor carried the board across the preheater. In the case of these tests, the preheater was a hotplate controlled at 370°C. The reason for this maximum temperature is the possibility of fire when using alcohol-based fluxes which can auto-ignite at 390°C. Another advantage of the water-based flux is the lack of flammability and the resulting increase in safety.

After numerous trails, the optimum preheat temperature measured on the topside of the printed circuit board was determined to be 105°C-120°C. This allowed for nearly complete evaporation of the water solvent and minimized spattering when the printed circuit board contacted the solder wave. The topside measurement was equivalent to a bottomside temperature on the 1.6 mm thick epoxy-glass circuit boards of 145°C-160°C, the ideal activating temperature of the flux which removes oxidation from the copper and/or tin-lead surfaces on the component leads and printed circuits.

After preparation by the flux across the preheater, the printed circuit board assembly was conveyed across the solder wave. The solder wave temperature for these tests was varied from 235°C up to 260°C with equally good soldering results with a variety of flux compositions of the first embodiment of the invention.

After soldering and cooling the test boards, visual examination revealed little or no visible flux residue, a property particularly desired for applications using test probes to evaluate electrical continuity. Additionally, certain soldered boards were tested to evaluate the effect of the flux residue on the insulation resistance properties of the circuit board. For this test, the "B" pattern (0.32-mm lines and spaces) of the IPC-B-25 comb pattern boards was used. After aging at 85°C and 85% relative humidity for 7 days at a constant bias of 50-volts, readings were taken at an applied 100-volts for one minute. The results in every case using the flux of the invention exceeded 1.6 x 10¹¹ ohms, considerably higher than the electronics industry acceptable value of 5.0 x 10⁸ ohms.

The soldering tests reveal that excellent soldering can be accomplished with the flux of the first embodiment of the invention. The amount of residue remaining is minimal and does not affect automated probe electrical testing or the surface insulation resistance of electronic circuit board assemblies.

In the second embodiment of the present invention, the VOC-free flux is formulated using flux solvent consisting essentially of demineralized water. The fluxing agent is dissolved in the demineralized water. Suitable fluxing agents are mono- and/or dicarboxylic acids and/or hydroxy acids. One or more nonionic surfactants are also present in the flux. The total solids content of the flux is less than about 5% by weight, with at least about 1% fluxing agent being required. Fluxing agent content in the range of form at least about 1% to about 4% by weight achieves the dual objectives of satisfactory fluxing without the need to clean the soldered area after application of solder. It has been observed that in the flux formulations of the second embodiment of the invention, fluxing is enhanced by using a plurality of fluxing agents.

The combination of acids suitable for use in the first embodiment of the invention are also suitable for use in the second embodiment of the invention. In the second embodiment of the invention, use of combined acids provides an expanded melting range at the elevated soldering temperature levels where the deionized water solvent is evaporated and also provides enhanced wetting. The combination of acids as in the first embodiment of the invention includes combinations of elevated/high melting point acids such as succinic and adipic acids and/or combinations of high melting acids mixed with smaller quantities of lower melting acids such as glutaric acids. In the second embodiment of the present invention, like the first embodiment of the present invention, combining acids achieves broadening of the fluxing agent melting range which falls within the range delimited by the solder melting point (solidus point) and the upper soldering temperatures; that is a temperature range typically from about 180°C to about 260°C. The combination of acids also enhances precleaning during preheating. It has been observed that there is an expanded window of flux activity when the melting range is increased.

The acids suitable as fluxing agents in the soldering flux of the second embodiment of the invention are the same acids suitable in the first embodiment of the invention.

In the second embodiment of the invention, where demineralized water without other cosolvents is used, the presence of surfactant is essential because surfactant is necessary to achieve acceptable levels of flux wet out or spread on the metal surface. Water has a high surface tension and the nonionic surfactant lowers the surface tension. Surfactants that act as foaming agents find added utility as additives for foam flux formation. The formula selected cannot foam too much or the foam head will be too stable to allow the flux bubbles to pop on the surface being fluxed and soldered. In the flux compositions of the second embodiment of the invention, the surfactant which is nonionic also provides the added and important attribute of enhancing the heat stability of the flux. Added heat stability impedes boil-away during soldering, which at the low flux agent content required by the present invention must be arrested/ameliorated.

Examples of nonionic surfactants that are suitable for use in the soldering fluxes of the second embodiment of the invention are: phenoxypolyethoxy ethanols; perfluoralkyl alcohols; glycol fatty acid esters such as glycerol monolaurate, and/or ethylene glycol distearate, alkylaryl polyether alcohols; tertiary acetylenic glycols; ethoxylated polyoxypropylenes; and alkoxylated phenols such as alkoxylated bisphenols. One or more nonionic surfactants may be used.

Soldering fluxes of the second embodiment of the invention are illustrated by reference to the non-limiting examples which follow below.

### EXAMPLE 4

| | |
|---|---|
| adipic acid | 1.5 weight % |
| succinic acid | 0.5 weight % |
| octylphenoxypolyethoxy ethanol | 0.1 weight % |
| deionized water | 97.9 weight % |

This composition, when used as a spray or wave flux, exhibits excellent soldering with resulting minimal residue and corrosion.

### EXAMPLE 5

| | |
|---|---|
| adipic acid | 1.5 weight % |
| glutaric acid | 0.3 weight % |
| glyceric acid | 0.2 weight % |
| perfluoroalkyl ethanol | 0.1 weight % |
| deionized water | 97.9 weight % |

This composition exhibits good properties as a foam flux.

### EXAMPLE 6

| | |
|---|---|
| pimelic acid | 1.0 weight % |
| azelaic acid | 0.3 weight % |
| phenylacetic acid | 0.1 weight % |
| phenoxypolyethoxy ethanol | 0.8 weight % |
| deionized water | 97.8 weight % |

This composition exhibited an excessive degree of foaming when used as a foam flux; however, the flux provided excellent solder filling of plated through holes in a printed circuit board.

### EXAMPLE 7

A series of experiments were conducted using the flux formulations of the second embodiment of the invention to evaluate the performance under production conditions. The equipment used for testing was an automatic wave soldering machine (Electrovert Mini-Pac) consisting of a foam fluxing stations, preheater and wave solder pot, all inline and over which a conveyor carries printed circuit board assemblies. The printed circuit board was mounted into a dual rail fixture which was placed onto the conveyor.

For this testing, a variety of printed circuit boards were used either to produce samples for further testing of the electrical properties of the flux residue or to evaluate the ideal machine control parameters for producing acceptable soldering. Printed circuit boards were the standard IPC (Institute for Interconnecting and Packaging Electronic Circuits) B-25 which contains plated through copper holes and comb patterns for insulation resistance testing. Also used were a variety of printed circuit boards with solder plating either unfused or fused as well as bare copper boards, all double-sided with plated through holes.

After the circuit boards were placed in the fixture and on the conveyor, they traveled at a speed of 1,5 m (5 feet) per minute across a wave of flux foam created by passing air into an aerating stone in the foam fluxing unit. It was found helpful to use a low volume air knife after the application of the flux to blow off any extra dripping flux, but this is not always necessary, depending on the action of the particular machine. Alternatively, the flux was applied by spraying to achieve a uniform coating on the circuit board surface.

An observation of the flux composition of the second embodiment of the invention during the eight hours of foaming established that both the specific gravity and acid number were little changed because of the aeration. The following measurements underscore the advantages of the flux of the present invention over its alcohol-based counterpart.

| Test Parameter | Water-based Flux | Alcohol-based Flux |
|---|---|---|
| | | |

| Specific gravity @ 25°C | | |
|---|---|---|
| Initial | 1.010 | 0.813 |
| 1-hour | 1.010 | 0.824 |
| 2-hours | 1.010 | 0.829 |
| 3-hours | 1.016 | 0.832 |
| 4-hours | 1.015 | 0.833 |
| 5-hours | 1.015 | 0.836 |
| 6-hours | 1.014 | 0.837 |
| 7-hours | 1.014 | 0.839 |
| 8-hours | 1.015 | 0.840 |
| Increase | 0.005 | 0.027 |

| Acid Number g KOH/Kg Flux | | |
|---|---|---|
| Initial | 21.19 | 13.89 |
| 1-hour | 21.19 | 14.99 |
| 2-hours | 21.23 | 16.34 |
| 3-hours | 21.23 | 16.76 |
| 4-hours | 21.60 | 18.62 |
| 5-hours | 21.63 | 19.14 |
| 6-hours | 21.59 | 19.86 |
| 7-hours | 22.09 | 20.34 |
| 8-hours | 21.81 | 21.18 |
| Increase | 0.62 | 7.29 |

The specific gravity is a direct indication of the rapid loss of the alcohol solvent as it evaporates into the atmosphere. This evaporation loss necessitates constant monitoring of the flux to replace the alcohol. The other measure of flux composition control is the acid number which is determined by titration and reported as grams of potassium hydroxide per liter of flux. As the solvent portion of the flux evaporates, the solids or active portion will increase accordingly.

It can readily be seen from the test data that the constant checking of flux composition required of the conventional alcohol-based fluxes is eliminated by using the water-based flux of the second embodiment of the invention.

After application of the flux to the bottomside of the printed circuit board, the conveyor carried the board across the preheater. In the case of these tests, the preheater was a hotplate controlled at 370°C. The reason for this maximum temperature is the possibility of fire when using alcohol-based fluxes which can auto-ignite at 390°C. Another advantage of the water-based flux is the lack of flammability and the resulting increase in safety.

After numerous trials, the optimum preheat temperature measured on the topside of the printed circuit board was determined to be 105°C-120°C. This allowed for nearly completed evaporation of the water solvent and minimized spattering when the printed circuit board contacted the solder wave. The topside measurement was equivalent to a bottomside temperature on the 1.6 mm thick epoxy-glass circuit boards of 145°C-160°C, the ideal activating temperature of the flux which removes oxidation from the copper and/or tin-lead surfaces on the component leads and printed circuits.

After preparation by the flux across the preheater, the printed circuit board assembly was conveyed across the solder wave. The solder wave temperature for these tests was varied from 235°C up to 260°C with equally good soldering results with a variety of flux compositions of the second embodiment of the invention.

After soldering and cooling the test boards, visual examination revealed little or no visible flux residue, a property particularly desired for applications using test probes to evaluate electrical continuity. Additionally, certain soldered boards were tested to evaluate the effect of the flux residue on the insulation resistance properties of the circuit board. For this test, the "B" boards were used. After aging at 85°C and 85% relative humidity for 7 days at a constant bias of 50-volts, readings were taken at an applied 100-volts for one minute. The results in every case using the flux of the invention exceeded 1.6 x 10¹¹ ohms, considerably higher than the electronics industry acceptable value of 5.0 x 10⁸ ohms.

The soldering tests reveal that excellent soldering can be accomplished with the flux of the second embodiment of the invention. The amount of residue remaining is minimal and does not affect automated probe electrical testing or the surface insulation resistance of electronic circuit board assemblies.

It will thus be seen that the objects set forth above, among those made apparent from the preceding description, are efficiently attained, and, since certain changes may be made in the above flux compositions without departing from the scope of the invention, it is intended that all matter contained in the above description shall be interpreted as illustrative and not in a limiting sense.

## Claims

1. A no-clean, low-residue, rosin-free foam soldering flux solution comprising:
a. at least about 95% by weight of a cosolvent system free of volatile organic compound solvents which is comprised of (i) at least about 90% by weight demineralized water based on total weight of the soldering flux solution and (ii) from about 1% by weight to about 5% by weight based on total weight of the soldering flux solution of a non-volatile organic solvent forming a cosolvent with said demineralized water, said nonvolatile organic solvent having a boiling point above about 190°C and a vapor pressure below 13,3 Pa (0.1 millimeters Hg) at 25°C;
b. from about 1% to about 4% by weight of fluxing agent consisting essentially of two or more carboxylic acids selected from the group consisting of C₂-C₁₀ dicarboxylic acids, monocarboxylic acids and hydroxy acids, said fluxing agent being present as solute in said cosolvent system; and
c. nonionic surfactant in an amount not exceeding about 1% by weight based on total weight of soldering flux solution.

2. The foam flux solution of claim 1 further comprising an anticorrosion agent present in an amount less than about 0.5% by weight based on total weight of the flux.

3. The foam flux solution of claims 1 or 2 wherein fluxing agent is present in an amount by weight based on total weight of the soldering flux of from about 2% to about 3%.

4. The foam flux solution of claims 1 or 2 wherein the fluxing agent contains a plurality of C₂-C₁₀ dicarboxylic acids.

5. The foam flux solution of claim 3 wherein the fluxing agent contains a plurality of C₂-C₁₀ dicarboxylic acids.

6. A soldering process, characterized by applying on the surfaces intended for soldering, prior to the soldering, a foam flux solution according to claim 1 and preheating said surfaces to vaporize the demineralized water solvent, following by heating to the temperature required for soldering.

7. The process of claim 6 wherein the soldering surfaces are soldering surfaces of silver, copper, tin, or alloys thereof.

8. The process of claim 6 wherein the soldering surface is copper or an alloy of copper on a circuit board.

9. A no-clean, low-residue, rosin-free soldering flux solution consisting essentially of:
a. demineralized water present in an amount of at least about 95% by weight based on total weight of the soldering flux solution;
b. from about 1% to about 4% by weight based on total weight of the soldering flux solution of a mixture of fluxing agents composed of at least two carboxylic acid fluxing agents selected from the group consisting of C₂-C₁₀ dicarboxylic acids, monocarboxylic acids and hydroxy acids, said carboxylic acid fluxing agents being present as solute in said demineralized water solvent; and
c. nonionic surfactant, said nonionic surfactant being present in an amount of less than about 1% by weight based on total weight of soldering flux solution.

10. The foam flux solution of claim 9 wherein the surfactant is present in an amount less than about 0.5% by weight.

11. The soldering flux of claims 9 or 10 wherein the content of carboxylic acid fluxing agents is from about 2% to about 3% by weight based on total weight of soldering flux solution.

12. The soldering flux of claims 9 or 10 wherein the carboxylic acid fluxing agents are a plurality of C₂-C₁₀ dicarboxylic acids.

13. The soldering flux of claim 11 wherein the carboxylic acid fluxing agents are a plurality of C₂-C₁₀ dicarboxylic acids.

14. A soldering process, characterized by applying on the surfaces intended for soldering, prior to the soldering, a foam flux solution according to claim 9 and preheating said surfaces to vaporize the demineralized water solvent, followed by heating to the temperature required for soldering.

15. A soldering process, characterized by applying on the surfaces intended for soldering, prior to the soldering, a foam flux solution according to claim 12 and preheating said surfaces to vaporize the demineralized water solvent, followed by heating to the temperature required for soldering.

16. A soldering process, characterized by applying on the surfaces intended for soldering, prior to the soldering, a foam flux solution according to claim 13 and preheating said surfaces to vaporize the demineralized water solvent, followed by heating to the temperature required for soldering.

17. The process of claim 14 wherein the soldering surfaces are soldering surfaces of silver, copper, tin, or alloys thereof.

18. The process of claim 14 wherein the soldering surface is copper or an alloy of copper on a circuit board.

## Patentansprüche

1. Rückstandsarme, kolophoniumfreie, keine Reinigung erfordernde Schaumlötflußmittellösung, umfassend
(a) mindestens ca. 95 Gew.% eines von flüchtigen organischen Verbindungen freien Hilfslösungsmittelsystems, das aus (i) mindestens ca. 90 Gew.%, bezogen auf das Gesamtgewicht der Lötflußmittellösung, demineralisiertem Wasser und (ii) ca. 1 Gew.% bis ca. 5 Gew.%, bezogen auf das Gesamtgewicht der Lötflußmittellösung, nichtflüchtigem organischen Lösungsmittel, das mit dem demineralisierten Wasser ein Hilfslösungsmittel bildet, wobei das nichtflüchtige organische Lösungsmittel einen Siedepunkt von über ca. 190°C und bei 25°C einen Dampfdruck von niedriger als 13,3 Pa (0,1 mmHg) aufweist, besteht,
(b) ca. 1 Gew.% bis ca. 4 Gew.% eines Flußmittels, das im wesentlichen aus zwei oder mehr Carbonsäuren, ausgewählt aus einer Gruppe umfassend C₂- bis C₁₀-Dicarbonsäuren, Monocarbonsäuren und Hydroxycarbonsäuren, wobei das Flußmittel als Gelöstes in dem Hilfslösungsmittelsystem vorliegt, sowie
(c) eine nicht-ionische oberflächenaktive Verbindung in einer Menge von nicht größer als ca. 1 Gew.%, bezogen auf das Gesamtgewicht der Lötflußmittellösung.

2. Schaumflußmittellösung nach Anspruch 1, die zusätzlich ein Korrosionsschutzmittel, das in einer Menge von weniger als ca. 0,5 Gew.%, bezogen auf das Gesamtgewicht des Flußmittels, vorliegt, umfaßt.

3. Schaumflußmittellösung nach Anspruch 1 oder 2, bei der das Flußmittel, bezogen auf das Gesamtgewicht des Lötflußmittels, in einem Gewichtsanteil von ca. 2 % bis ca. 3 % vorliegt.

4. Schaumflußmittellösung nach Anspruch 1 oder 2, bei der das Flußmittel mehrere C₂- bis C₁₀-Dicarbonsäuren enthält.

5. Schaumflußmittellösung nach Anspruch 3, bei der das Flußmittel mehrere C₂- bis C₁₀-Dicarbonsäuren enthält.

6. Lötverfahren, gekennzeichnet durch das Aufbringen einer Schaumflußmittellösung gemäß Anspruch 1 auf die zum Verlöten vorgesehenen Oberflächen vor dem Löten und das Vorerhitzen der Oberflächen zum Verdampfen des Lösungsmittels aus demineralisiertem Wasser, gefolgt vom Erhitzen auf die für das Löten erforderliche Temperatur.

7. Verfahren nach Anspruch 6, bei dem die Lötflächen aus Silber, Kupfer oder Zinn oder aus Legierungen hiervon sind.

8. Verfahren nach Anspruch 6, bei dem die Lötfläche Kupfer oder eine Kupferlegierung auf einer Leiterplatte ist.

9. Rückstandsarme, kolophoniumfreie, keine Reinigung erfordernde Lötflußmittellösung, bestehend im wesentlichen aus
(a) demineralisiertem Wasser in einer Menge von mindestens ca. 95 Gew.%, bezogen auf das Gesamtgewicht der Lötflußmittellösung,
(b) ca. 1 Gew.% bis ca. 4 Gew.%, bezogen auf das Gesamtgewicht der Lötflußmittellösung, einer Flußmittelmischung, zusammengesetzt aus mindestens zwei Carbonsäure-Flußmitteln ausgewählt aus der Gruppe bestehend aus C₂- bis C₁₀-Dicarbonsäuren, Monocarbonsäuren und Hydroxycarbonsäuren, wobei die Carbonsäure-Flußmittel als Gelöstes in dem als Lösungsmittel verwendeten demineralisierten Wasser vorliegen, und
(c) einer nicht-ionischen oberflächenaktiven Verbindung in einer Menge von weniger als ca. 1 Gew.%, bezogen auf das Gesamtgewicht der Lötflußmittellösung.

10. Schaumflußmittellösung nach Anspruch 9, bei der die oberflächenaktive Verbindung in einer Menge von weniger als ca. 0,5 Gew.% vorliegt.

11. Lötflußmittel nach Anspruch 9 oder 10, bei dem der Gehalt an Carbonsäure-Flußmitteln ca. 2 Gew.% bis ca. 3 Gew.%, bezogen auf das Gesamtgewicht der Lötflußmittellösung, beträgt.

12. Lötflußmittel nach Anspruch 9 oder 10, bei dem die Carbonsäure-Flußmittel mehrere C₂- bis C₁₀-Dicarbonsäuren sind.

13. Lötflußmittel nach Anspruch 11, bei dem die Carbonsäure-Flußmittel mehrere C₂- bis C₁₀-Dicarbonsäuren sind.

14. Lötverfahren, gekennzeichnet durch das Aufbringen einer Schaumflußmittellösung gemäß Anspruch 9 auf die zum Verlöten vorgesehenen Oberflächen vor dem Löten und das Vorerhitzen der Oberflächen zum Verdampfen des Lösungsmittels aus demineralisiertem Wasser, gefolgt vom Erhitzen auf die für das Löten erforderliche Temperatur.

15. Lötverfahren, gekennzeichnet durch das Aufbringen einer Schaumflußmittellösung gemäß Anspruch 12 auf die zum Verlöten vorgesehenen Oberflächen vor dem Löten und das Vorerhitzen der Oberflächen zum Verdampfen des Lösungsmittels aus demineralisiertem Wasser, gefolgt vom Erhitzen auf die für das Löten erforderliche Temperatur.

16. Lötverfahren, gekennzeichnet durch das Aufbringen einer Schaumflußmittellösung gemäß Anspruch 13 auf die zum Verlöten vorgesehenen Oberflächen vor dem Löten und das Vorerhitzen der Oberflächen zum Verdampfen des Lösungsmittels aus demineralisiertem Wasser, gefolgt vom Erhitzen auf die für das Löten erforderliche Temperatur.

17. Verfahren nach Anspruch 14, bei dem die Lötflächen aus Silber, Kupfer oder Zinn oder aus Legierungen hiervon sind.

18. Verfahren nach Anspruch 14, bei dem die Lötfläche Kupfer oder eine Kupferlegierung auf einer Leiterplatte ist.

## Revendications

1. Solution de flux décapant sous forme de mousse, ne nécessitant pas de nettoyage, laissant peu de résidus, exempt de colophane comprenant :
a. au moins environ 95% en poids d'un système de co-solvants exempt de solvants du type composés organiques volatils qui est constitué (i) d'au moins 90% en poids d'eau déminéralisée par rapport au poids total de la solution de flux décapant et (ii) d'environ 1% en poids à environ 5% en poids par rapport au poids total de la solution de flux décapant d'un solvant organique non-volatil formant un co-solvant avec ladite eau déminéralisée, ledit solvant organique non-volatil ayant un point d'ébullition supérieur à 190°C environ et une pression de vapeur inférieure à 13,3 Pa (0,1 millimètres Hg) à 25°C;
b. environ 1% à environ 4% en poids d'un agent de flux constitué essentiellement de deux ou plusieurs acides carboxyliques choisis dans le groupe constitué par les acides dicarboxyliques en C₂-C₁₀, les acides monocarboxyliques et les hydroxy-acides, ledit agent de flux étant présent sous forme de soluté dans ledit système de co-solvants; et
c. un agent tensioactif non ionique en une quantité n'excédant pas environ 1% en poids par rapport au poids total de la solution de flux décapant.

2. Solution de flux sous forme de mousse selon la revendication 1 comprenant en outre un agent anticorrosion présent en une quantité inférieure à environ 0,5% en poids par rapport au poids total du flux.

3. Solution de flux sous forme de mousse selon la revendication 1 ou 2 dans laquelle l'agent de flux est présent en une quantité d'environ 2% à environ 3% en poids par rapport au poids total du flux décapant.

4. Solution de flux sous forme de mousse selon la revendication 1 ou 2, l'agent de flux contenant un grand nombre d'acides dicarboxyliques en C₂-C₁₀.

5. Solution de flux sous forme de mousse selon la revendication 3, l'agent de flux contenant un grand nombre d'acides dicarboxyliques en C₂-C₁₀.

6. Procédé de brasage, consistant à appliquer, avant le brasage, sur les surfaces destinées à être brasées une solution de flux sous forme de mousse selon la revendication 1 et à préchauffer lesdites surfaces pour vaporiser l'eau déminéralisée du solvant, puis à chauffer à la température requise pour le brasage.

7. Procédé selon la revendication 6 dans lequel les surfaces à braser sont des surfaces d'argent, de cuivre, d'étain, ou d'alliages de ces métaux.

8. Procédé selon la revendication 6 dans lequel la surface à braser est du cuivre ou un alliage de cuivre sur une plaque de circuit imprimé.

9. Solution de flux décapant sous forme de mousse, ne nécessitant pas de nettoyage, laissant peu de résidus, exempt de colophane constituée essentiellement :
a. d'eau déminéralisée présente en quantité d'au moins environ 95% en poids par rapport au poids total de la solution de flux décapant;
b. d'environ 1% à environ 4% en poids par rapport au poids total de la solution de flux décapant d'un mélange d'agents de flux composé d'au moins deux agents de flux du type acide carboxylique choisis dans le groupe constitué par les acides dicarboxyliques en C₂-C₁₀, les acides monocarboxyliques et les hydroxy-acides, lesdits agents de flux du type acide carboxylique étant présents sous forme de soluté dans ledit solvant d'eau déminéralisée; et
c. d'un agent tensioactif non ionique, ledit agent tensioactif non ionique étant présent en une quantité inférieure à 1% en poids par rapport au poids total de la solution de flux décapant.

10. Solution de flux décapant sous forme de mousse selon la revendication 9 dans laquelle l'agent tensioactif est présent en une quantité inférieure à 0,5% en poids environ.

11. Solution de flux décapant selon les revendications 9 ou 10 dans laquelle la teneur en agents de flux du type acide carboxylique est d'environ 2% à environ 3% en poids par rapport au poids total de la solution de flux décapant.

12. Solution de flux décapant selon les revendications 9 ou 10, dans laquelle les agents de flux du type acide carboxylique sont un grand nombre d'acides dicarboxyliques en C₂-C₁₀.

13. Solution de flux décapant selon la revendication 11, dans laquelle les agents de flux du type acide carboxylique sont un grand nombre d'acides dicarboxyliques en C₂-C₁₀.

14. Procédé de brasage, consistant à appliquer, avant le brasage, sur les surfaces destinées à être brasées une solution de flux sous forme de mousse selon la revendication 9 et à préchauffer lesdites surfaces pour vaporiser l'eau déminéralisée du solvant, puis à chauffer à la température requise pour le brasage.

15. Procédé de brasage, consistant à appliquer, avant le brasage, sur les surfaces destinées à être brasées une solution de flux sous forme de mousse selon la revendication 12 et à préchauffer lesdites surfaces pour vaporiser l'eau déminéralisée du solvant, puis à chauffer à la température requise pour le brasage.

16. Procédé de brasage, consistant à appliquer, avant le brasage, sur les surfaces destinées à être brasées une solution de flux sous forme de mousse selon la revendication 13 et à préchauffer lesdites surfaces pour vaporiser l'eau déminéralisée du solvant, puis à chauffer à la température requise pour le brasage.

17. Procédé selon la revendication 14 dans lequel les surfaces à braser sont des surfaces d'argent, de cuivre, d'étain, ou d'alliages de ces métaux.

18. Procédé selon la revendication 14 dans lequel la surface à braser est du cuivre ou un alliage de cuivre sur une plaque de circuit imprimé.
